# EUROPEAN PATENT APPLICATION

(11) **EP 4 224 519 A1**
(43) Date of publication of application: **09.08.2023**
(21) Application number: 21875557.7
(22) Date of filing: 28.09.2021
(51) Int. Cl.: H01L 23/02, H01L 23/04, H01L 23/12, H05K 1/02, H05K 3/46

(54) **WIRING BASE AND ELECTRONIC DEVICE**

(30) Priority: 30.09.2020 JP 2020165236
(71) Applicant: Kyocera Corporation, Kyoto-shi Kyoto 612-8501 (JP)
(72) Inventor: KAWAZU, Yoshiki, Kyoto-shi, Kyoto 612-8501 (JP); KIMURA, Taito, Kyoto-shi, Kyoto 612-8501 (JP)
(74) Representative: Viering, Jentschura & Partner mbB Patent- und Rechtsanwälte
(86) International application number: PCT/JP2021/035477
(87) International publication number: WO 2022/071256

(57) **Abstract**

A wiring base includes a base, a signal conductor, and a ground conductor including a first ground conductor. The base includes a first surface, a first region, and a second region. The first region is located near an outer side of the first surface. An external board is mounted in the first region. The second region is other than the first region. The signal conductor extends through a region including the first region of the first surface in a first direction away from the outer side. The first ground conductor is located in the base at a distance from the signal conductor of less than 1/4 of a wavelength of a high-frequency signal. The high-frequency signal is transmitted through the signal conductor. The first ground conductor includes a first grid portion at a first location overlapping the first region and at least a portion of the signal conductor in a see-through plan view viewed in a direction toward the first surface. The first grid portion includes a segment disposed between first openings. Lengths of the first openings in the first direction and a second direction crossing the first direction are 1/8 or more and 1/4 or less of the wavelength. A through conductor is located on the first grid portion.

## Description

### TECHNICAL FIELD

The present disclosure relates to a wiring base and an electronic device.

### BACKGROUND OF INVENTION

A known wiring base (for example, a package) includes an electronic component mounted therein and provides electrical connection between the electronic component and an external wiring line. The wiring base may include a main body containing the electronic component and a terminal member extending out of the main body. The terminal member includes a signal conductor and a ground conductor that are electrically connected to the electronic component. When an external board is mounted to the terminal member, a wiring line of the external board is electrically connected to the electronic component.

A known terminal member includes a signal line (microstrip line) that enables transmission of a high-frequency signal. The signal line includes a signal conductor and a ground conductor facing the signal conductor across an insulator. International Publication No. 2010/103722, for example, describes a technology for adjusting the impedance of the signal line by forming openings in a mesh pattern in the ground conductor of the terminal member.

### SUMMARY

According to an aspect of the present disclosure, a wiring base includes a base, a signal conductor, and a ground conductor including a first ground conductor. The base includes a first surface, a first region, and a second region. The first region is located near an outer side of the first surface. An external board is mounted in the first region. The second region is other than the first region. The signal conductor extends through a region including the first region of the first surface in a first direction away from the outer side. The first ground conductor is located in the base at a distance from the signal conductor of less than 1/4 of a wavelength of a high-frequency signal in a direction perpendicular to the first surface. The high-frequency signal is transmitted through the signal conductor. The first ground conductor includes a first grid portion at a first location overlapping the first region and at least a portion of the signal conductor in a see-through plan view viewed in a direction toward the first surface. The first grid portion includes a segment disposed between first openings. Lengths of the first openings in the first direction and a second direction crossing the first direction are 1/8 or more and 1/4 or less of the wavelength of the high-frequency signal. A through conductor is located on the first grid portion.

According to another aspect of the present disclosure, an electronic device includes the above-described wiring base and an electronic component connected to the wiring base.

### BRIEF DESCRIPTION OF THE DRAWINGS

FIG. 1 is a perspective view of an electronic device according to a first embodiment.
FIG. 2 is a plan view of the electronic device and a wiring base.
FIG. 3 illustrates a first layer of a terminal member.
FIG. 4 illustrates a second layer of the terminal member.
FIG. 5 illustrates a third layer of the terminal member.
FIG. 6 is an enlarged view of the third layer of the terminal member.
FIG. 7 is an enlarged view illustrating another example of the third layer of the terminal member.
FIG. 8 illustrates a fourth layer of the terminal member.
FIG. 9 illustrates a fifth layer of the terminal member.
FIG. 10 illustrates the result of a simulation of reflection loss of the wiring base.
FIG. 11 illustrates the result of a simulation of insertion loss of the wiring base.
FIG. 12 illustrates first to fourth layers of a terminal member according to a second embodiment.
FIG. 13 illustrates a terminal member according to another embodiment.
FIG. 14 illustrates a terminal member according to another embodiment.

### DESCRIPTION OF EMBODIMENTS

Embodiments will be described with reference to the drawings. Note that, for convenience of description, the drawings referred to below are simplified and illustrate only main components necessary to describe the embodiments. Therefore, a wiring base 100 and an electronic device 1 according to the present disclosure may include any components that are not illustrated in the drawings referred to below. Dimensions of components illustrated in the drawings do not accurately reflect the actual dimensions and dimensional ratios of the components.

### <First Embodiment>

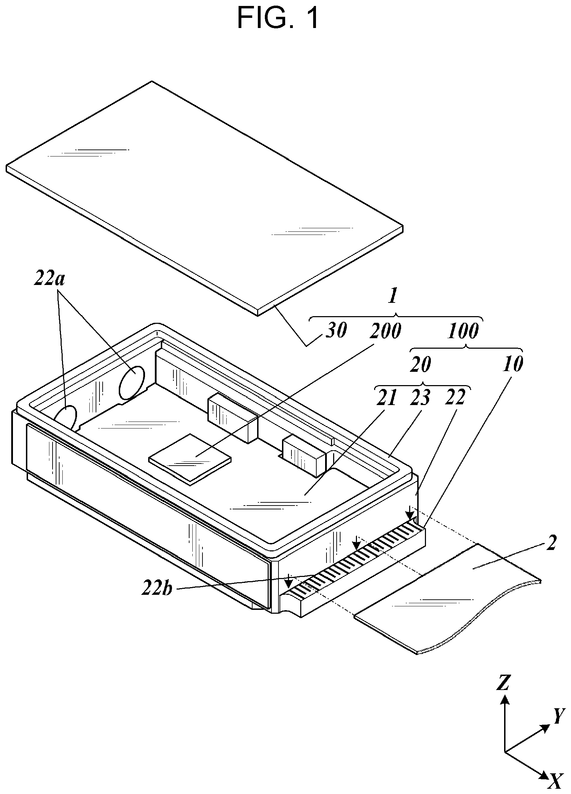

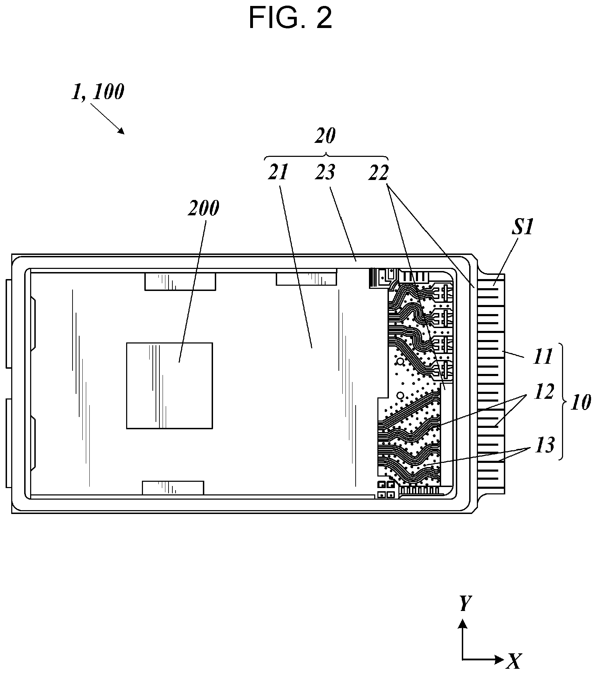

The structure of the electronic device 1 according to a first embodiment will be described with reference to FIGs. 1 and 2.

The electronic device 1 includes the wiring base 100 and an electronic component 200. The electronic device 1 also includes a lid body 30 sealing the wiring base 100.

The wiring base 100 includes a main body 20 and a terminal member 10. The terminal member 10 extends out of the main body 20. When the electronic device 1 includes the lid body 30, the lid body 30 may be regarded as sealing the main body 20. The wiring base 100 is an electronic device package including the main body 20 in which the electronic component 200 is mounted. The electronic device package provides electrical connection between the electronic component 200 and wiring lines of an external board 2 through the terminal member 10. In the present embodiment, the wiring base 100 holds, for example, the electronic component 200 for optical communication. In this case, the electronic component 200 may receive or output a high-frequency signal for optical communication (for example, the modulation rate is about 96 Gbaud or less and the frequency band is about 75 GHz or less). For example, the electronic component 200 may be a light emitting element or a light receiving element. These are examples, and the electronic component 200 to be mounted is not limited to the above-described elements.

The main body 20 includes a bottom portion 21, a frame 22, and a seal member 23. The bottom portion 21 is a rectangular plate-shaped member. In the following description, directions parallel to the sides of the rectangular bottom portion 21 are referred to as an X direction and a Y direction, and a direction perpendicular to the bottom portion 21 and extending from the bottom portion 21 toward the lid body 30 is referred to as a Z direction. Among surfaces of any component that are parallel to the XY plane, a surface facing in the +Z direction is referred to as an "upper surface", and a surface facing in the -Z direction is referred to as a "lower surface". A layer located in the -Z direction relative to another object is referred to as a layer "below" the object. A view in the Z direction is referred to as a "plan view", and a see-through view seen through other components in the Z direction is referred to as a "see-through plan view".

An upper surface of the bottom portion 21 includes a placement region in which the electronic component 200 is placed. The electronic component 200 placed in the placement region includes terminals electrically connected to wiring lines formed on the upper surface of the bottom portion 21.

The frame 22 is a frame-shaped member surrounding the placement region for the electronic component 200 in plan view. In the present embodiment, the frame 22 extends in the +Z direction from an outer peripheral portion of the bottom portion 21 to form a frame-shaped side wall. The frame 22 may include through holes 22a for allowing optical fibers or the like to extend therethrough.

Each of the bottom portion 21 and the frame 22 may, for example, include a plurality of insulative boards stacked in the Z direction. Each insulative board may be, for example, a ceramic sintered body, such as an aluminum-oxide-based sintered body, an aluminum-nitride-based sintered body, a silicon-carbide-based sintered body, a mullite-based sintered body, or a glass ceramic. The frame 22 may be separate from the bottom portion 21 or be formed integrally with the bottom portion 21.

The seal member 23 is disposed on an upper surface of the frame 22. The seal member 23 may be used as a material for sealing the main body 20 with the lid body 30 in an airtight manner after the electronic component 200 is mounted on the bottom portion 21. The seal member 23 may be formed by, for example, joining a frame-shaped metal plate to a frame-shaped conductor by brazing with a brazing material or the like. The frame-shaped conductor is formed from a conductor paste containing a high-melting-point metal, such as tungsten or molybdenum. The frame-shaped metal plate includes a metal plate made of a Fe-Ni-based alloy or a Fe-Ni-Co-based alloy.

The lid body 30 is a plate-shaped member having substantially the same shape as the shape of the bottom portion 21 in plan view. The lid body 30 may be any member capable of reducing entrance of foreign matter, such as moisture and fine particles, into the electronic device 1. The lid body 30 may be obtained by, for example, forming the same metal material as the material of the seal member 23, the same ceramic material as the material of the bottom portion 21 and the frame 22, or the like into a plate shape. In the following description, a space defined by the bottom portion 21, the frame 22, and the lid body 30 is referred to as a cavity.

A side wall of the frame 22 at an end of the frame 22 in the +X direction includes a fitting portion 22b extending through the side wall in a thickness direction (X direction). The terminal member 10 is shaped to fit the fitting portion 22b. The terminal member 10 extends from a location inside (in the -X direction from) the fitting portion 22b to a location outside (in the +X direction from) the fitting portion 22b, and blocks the fitting portion 22b. The terminal member 10 is fitted to the fitting portion 22b and fixed to the frame 22 with a brazing material or the like. The terminal member 10 may be a portion of a multilayer structure of the frame 22.

The terminal member 10 includes a base 11 including a dielectric, signal conductors 12, and a ground conductor 13. The terminal member 10 includes a portion protruding from the main body 20 and having a first surface S1 facing in the +Z direction. The signal conductors 12 and the ground conductor 13 are partially exposed at the first surface S1. As illustrated in FIG. 1, the external board 2 is connected to the first surface S1. Accordingly, the wiring lines on a surface of the external board 2 facing in the -Z direction are electrically connected to the signal conductors 12 and the ground conductor 13 on the first surface S1 of the terminal member 10. The signal conductors 12 and the ground conductor 13 are electrically connected to terminals of the electronic component 200 by the wiring lines formed on the bottom portion 21 or the like. Thus, the terminal member 10 provides electrical connection between the wiring lines on the external board 2 and the terminals of the electronic component 200.

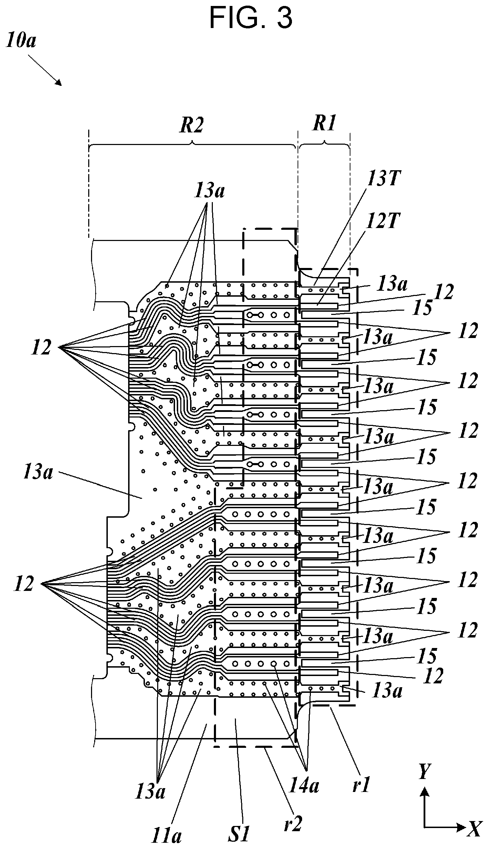

The structure of the terminal member 10 will now be described in detail with reference to FIGs. 3 to 9.

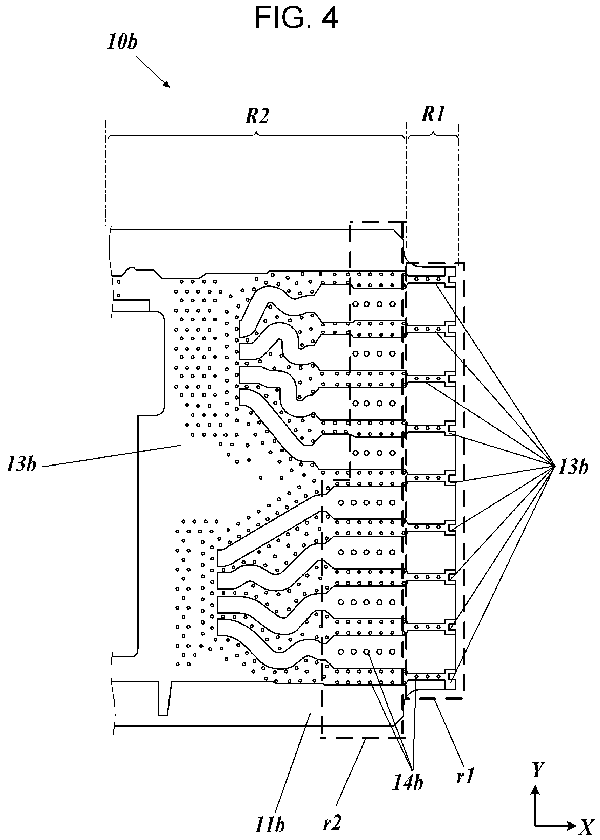

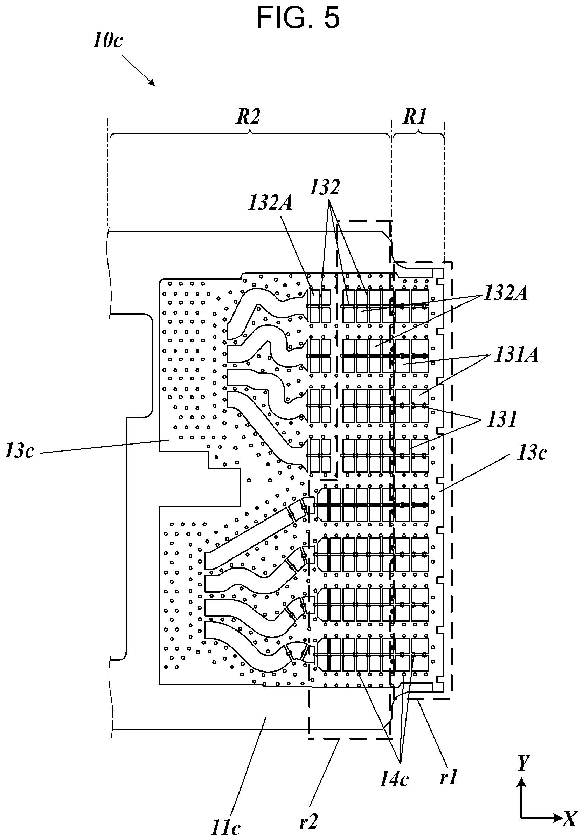

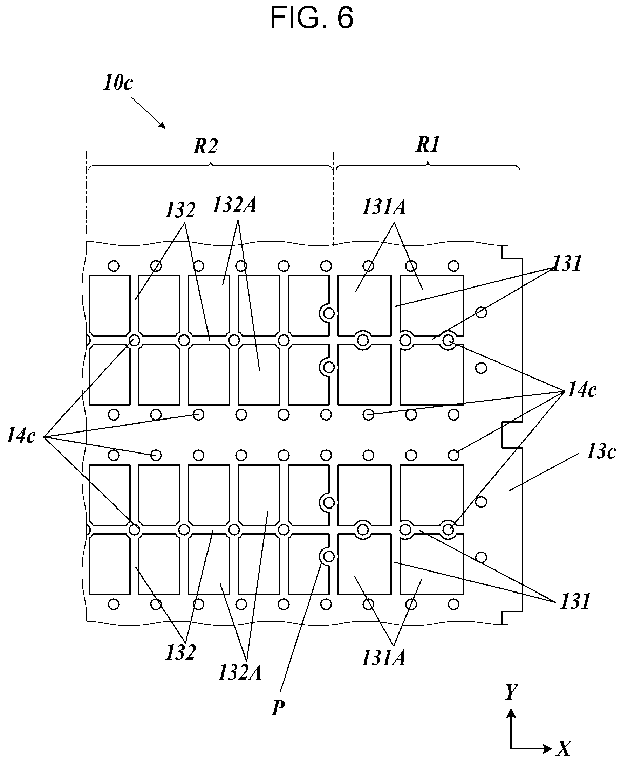

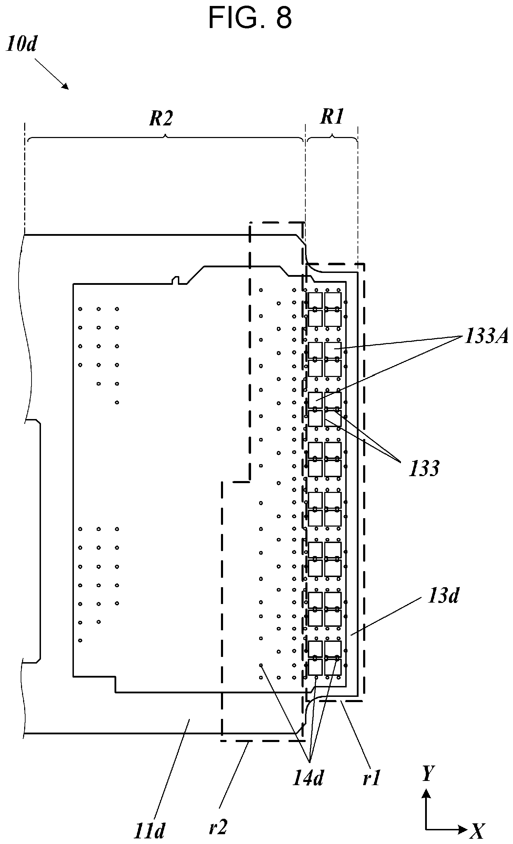

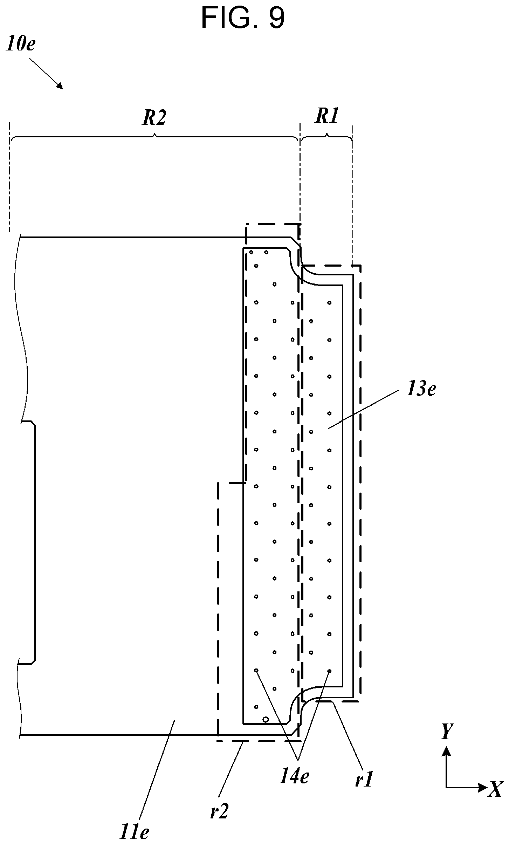

The terminal member 10 includes a first layer 10a (FIG. 3), a second layer 10b (FIG. 4), a third layer 10c (FIGs. 5 and 6), a fourth layer 10d (FIG. 8), and a fifth layer 10e (FIG. 9). The first layer 10a to the fifth layer 10e are stacked in that order in the -Z direction. The first layer 10a is located furthest in the +Z direction. The terminal member 10 may further include a sixth layer and a seventh layer located further in the -Z direction than the fifth layer 10e.

As illustrated in FIG. 3, the first layer 10a includes a base 11a, the signal conductors 12, ground conductors 13a, and through conductors 14a. The base 11a is a flat plate-shaped dielectric and includes the first surface S1 (upper surface). The base 11a also includes a first region R1 and a second region R2. The first region R1 is near an outer side of the first surface S1 (side extending in the Y direction at an end in the +X direction), and the external board 2 is mounted in the first region R1. The second region R2 is other than the first region R1.

The first region R1 of the base 11a is a rectangular region extending in the Y direction in plan view, and is exposed to the outside of the wiring base 100. The external board 2 is connected and mounted to the first region R1. In FIG. 3, the dashed line rectangle indicates a mounting region r1 in which the external board 2 is connected in plan view.

The second region R2 of the base 11a includes a frame region r2 disposed adjacent to the first region R1 and overlapping the frame 22 in plan view. The second region R2 extends beyond the frame region r2 into the inside of the frame 22 (that is, the inside of the cavity).

The signal conductors 12 and the ground conductors 13a are formed on an upper surface of the base 11a.

The signal conductors 12 extend along a region including the first region R1 of the first surface S1 in a first direction (X direction) away from the outer side. The signal conductors 12 may extend straight in the X direction in the first region R1 and the frame region r2 of the second region R2. The signal conductors 12 may extend in a curved manner to predetermined locations at an end portion in the -X direction in a portion of the second region R2 corresponding to the inside of the cavity. The signal conductors 12 may include portions disposed in the first region R1 and serving as rectangular signal terminals 12T. The signal terminals 12T have a predetermined width in the Y direction to enable electrical connection to the wiring lines on the external board 2. The signal conductors 12 may include portions disposed in the frame region r2 and having a width less than that of the signal terminals 12T in the Y direction. In the present embodiment, the terminal member 10 includes sixteen signal conductors 12. The number of signal conductors 12 may be changed as appropriate in accordance with the number of terminals of the electronic component 200 that is mounted.

The ground conductors 13a extend along a region including the first region R1 of the first surface S1 in the first direction (X direction) away from the outer side. The ground conductors 13a may extend straight in the X direction in the first region R1 and the frame region r2 of the second region R2. The ground conductors 13a may extend in a curved manner to predetermined locations at the end portion in the -X direction in the portion of the second region R2 corresponding to the inside of the cavity. The signal conductors 12 include portions disposed in the first region R1 and serving as ground terminals 13T to which the wiring lines on the external board 2 are connected.

In the present embodiment, the terminal member 10 includes nine ground conductors 13a. Each ground conductor 13a has a ground potential. Two of the ground conductors 13a are located on both sides of the sixteen signal conductors 12, that is, at both ends of the first layer 10a in the Y direction. The remaining seven ground conductors 13a are located such that two of the signal conductors 12 are disposed between adjacent ones of the ground conductors 13a. In other words, the ground conductors 13a and the signal conductors 12 are arranged in the Y direction in a periodic pattern of one ground conductor 13a, two signal conductors 12, one ground conductor 13a, and so on. The number of ground conductors 13 may be changed as appropriate in accordance with the number of terminals of the electronic component 200 that is mounted.

The base 11a may include a groove 15 between each pair of adjacent ones of the signal terminals 12T with no ground terminal 13T disposed therebetween. The groove 15 is filled with air and have a low relative dielectric constant. Therefore, the electric field coupling between the pair of signal terminals 12T is reduced compared to when no groove 15 is provided. The groove 15 may extend to an end of the base 11a or be formed only between the signal terminals 12T. Accordingly, adverse effects, such as cross-talk noise, caused by electromagnetic interference between the signal terminals 12T can be reduced. The wiring base 100 of the above-described structure has good transmission characteristics for high-frequency signals.

Each ground conductor 13a may be connected to the through conductors 14a extending through the base 11a in the Z direction. In FIG. 3, the circular dots indicate the locations of the through conductors 14. The through conductors 14 are arranged at regular intervals along the contours of the ground conductors 13a in regions overlapping the ground conductors 13a in see-through plan view. In the frame region r2, the through conductors 14 are formed between each pair of adjacent ones of the signal conductors 12 with no ground conductor 13a disposed therebetween. The through conductors 14a may, for example, have a cylindrical shape. However, the shape of the through conductors 14a is not limited to this. This also applies to through conductors 14b to 14e described below.

As illustrated in FIG. 4, the second layer 10b includes a flat plate-shaped base 11b including a dielectric, a ground conductor 13b, and through conductors 14b. The base 11b includes a first region R1 and a second region R2. The second layer 10b overlaps the first layer 10a such that the first region R1 of the base 11b and the first region R1 of the base 11a coincide in see-through plan view. In FIG. 4 (and also in FIGs. 5, 8, and 9), the dashed lines indicate the areas overlapping the mounting region r1 and the frame region r2 in see-through plan view.

The ground conductor 13b is formed on an upper surface of the base 11b. The ground conductor 13b includes portions overlapping the ground conductors 13a of the first layer 10a in see-through plan view and a portion connecting the ends of these portions in the -X direction together. In another respect, the ground conductor 13b has the shape of a flat conductor from which portions are removed, the portions overlapping regions including and surrounding the signal conductors 12 of the first layer 10a in see-through plan view. An upper surface of the ground conductor 13b is connected to the through conductors 14a of the first layer 10a. Accordingly, the ground conductor 13b is electrically connected to the ground conductors 13a of the first layer 10a via the through conductors 14a and has the ground potential. The ground conductor 13b is also connected to the through conductors 14b extending through the base 11b in the Z direction.

The second layer 10b is provided mainly to adjust the distance between the first layer 10a and the third layer 10c or to adjust the impedance of the terminal member 10. Therefore, the second layer 10b may be omitted when the adjustment of the distance or the impedance is not unnecessary.

As illustrated in FIG. 5, the third layer 10c includes a flat plate-shaped base 11c including a dielectric, a ground conductor 13c (first ground conductor), and through conductors 14c. The base 11c includes a first region R1 and a second region R2. The third layer 10c overlaps the second layer 10b such that the first region R1 of the base 11c and the first region R1 of the base 11b coincide in see-through plan view. The base 11c has a shape that is substantially the same as the shape of the base 11b.

The ground conductor 13c is formed on an upper surface of the base 11c. When λ is the wavelength of a high-frequency signal transmitted through the signal conductors 12, the ground conductor 13c is located at a distance of less than λ/4 from the signal conductors 12 in the direction perpendicular to the first surface S1 (Z direction). The ground conductor 13c includes portions overlapping the ground conductor 13b of the second layer 10b in see-through plan view. The ground conductor 13c also includes a plurality of first openings 131A in the first region R1. The ground conductor 13c also includes a plurality of second openings 132A in the second region R2 in an area within a predetermined distance in the -X direction from the boundary between the second region R2 and the first region R1. More specifically, the second openings 132A are formed in an area overlapping the frame region r2 in see-through plan view. In a section further in the +Y direction than the center of the third layer 10c in the Y direction, the second openings 132A are also formed in an area that is further in the -X direction than the frame region r2, that is, in an area inside the cavity.

The first openings 131A and the second openings 132A are arranged next to each other in the X direction and the Y direction in a matrix pattern. In other words, the ground conductor 13c includes the first openings 131A and the second openings 132A in a mesh pattern. The ground conductor 13c includes a first grid portion 131 and a second grid portion 132. The first grid portion 131 includes segments disposed between the first openings 131A that are adjacent to each other. The second grid portion 132 includes segments disposed between the second openings 132A that are adjacent to each other. Each of the first grid portion 131 and the second grid portion 132 is a conductor including straight segments extending in the X direction and the Y direction. The ground conductor 13c also includes a straight grid portion extending in the Y direction at the boundary between the first region R1 and the second region R2. The straight grid portion includes segments disposed between the first openings 131A and the second openings 132A that are adjacent to each other.

In the following description, the first openings 131A and the second openings 132A arranged in one row in the X direction will be referred to as an "opening row". The ground conductor 13c includes sixteen opening rows corresponding to the sixteen signal conductors 12. Each opening row overlaps one of the signal conductors 12 in see-through plan view. More specifically, the center of each opening row in the Y direction overlaps one of the signal conductors 12. Therefore, the segments of the first grid portion 131 extending in the Y direction and disposed between the first openings 131A adjacent to each other in the X direction in each opening row are orthogonal to the corresponding signal conductor 12 in see-through plan view. The segments of the second grid portion 132 extending in the Y direction and disposed between the second openings 132A adjacent to each other in the X direction in each opening row are also orthogonal to the corresponding signal conductor 12 in see-through plan view. Thus, the ground conductor 13c includes the first grid portion 131 at a location (first location) overlapping the first region R1 and at least portions of the signal conductors 12 in see-through plan view. The ground conductor 13c also includes the second grid portion 132 at a location (second location) connected to the first grid portion 131 in the X direction and overlapping the second region R2 and at least portions of the signal conductors 12 in see-through plan view.

An upper surface of the ground conductor 13c is connected to the through conductors 14b of the second layer 10b. Accordingly, the ground conductor 13c is electrically connected to the ground conductor 13b of the second layer 10b via the through conductors 14b and has the ground potential. The ground conductor 13c is also connected to the through conductors 14c extending through the base 11c in the Z direction.

The shapes of the first openings 131A and the second openings 132A of the third layer 10c and the arrangement of the through conductors 14c will now be described in detail with reference to FIG. 6.

As illustrated in FIG. 6, the first openings 131A and the second openings 132A have a rectangular shape with sides extending in the X direction (first direction) and the Y direction (second direction). The rectangular shape is not limited to a shape including four corners with precise right angles (rectangle). The second direction may also be referred to as a direction crossing the first direction.

For example, the rectangular shape includes a polygonal shape formed by chamfering one or more corners of a rectangle. A shape with a chamfered corner is a shape in which two of the four sides of a rectangle forming the corner are connected to each other with a side that is not parallel to either of the two sides.

The rectangular shape may also include a shape in which the sides of a rectangle are connected with curves. Thus, according to the present disclosure, the rectangular shape includes the shape of an opening designed to have the shape of a rectangle but formed as an opening with curved corners in practice due to limitations in manufacturing processes.

The rectangular shape may also include a shape including one or more sides at which one or more protrusions P protrude, each protrusion P overlapping one of the through conductors 14c in plan view.

The lengths of the first openings 131A and the second openings 132A in the X direction and the Y direction are λ/8 or more and λ/4 or less. The area of each of the first openings 131A is greater than the area of each of the second openings 132A. More specifically, the first openings 131A and the second openings 132A have the same width in the Y direction, and the width of each of the first openings 131A in the X direction is greater than the width of each of the second openings 132A in the X direction.

The through conductors 14c are located on the first grid portion 131 and the second grid portion 132. In other words, the through conductors 14c are located to overlap the first grid portion 131 and the second grid portion 132 in plan view, and are connected to the first grid portion 131 and the second grid portion 132. More specifically, the through conductors 14c are located to overlap the segments of the first grid portion 131 extending in the X direction. The through conductors 14c are also located to overlap the grid portion extending in the Y direction at the boundary between the first region R1 and the second region R2. The through conductors 14c are also located at the intersections of the second grid portion 132. The through conductors 14c are also located around the first openings 131A and the second openings 132A. The distance from each through conductor 14c to an adjacent one of the through conductors 14c is less than λ/4. In other words, at least one through conductor 14c is disposed within a distance of λ/4 from each through conductor 14c on the XY plane.

The through conductors 14b of the second layer 10b are located to overlap some of the through conductors 14c in see-through plan view. In the example illustrated in FIGs. 4 and 5, the through conductors 14b and 14c located in the second region R2 overlap in see-through plan view. In particular, the through conductors 14b and 14c are located at the intersections of the second grid portion 132 in see-through plan view. This enables a dense arrangement of the through conductors 14b and 14c in the region in which the second openings 132A are formed in a mesh pattern. In other words, each of the through conductors 14b and a corresponding one of the through conductors 14c are located on a straight line extending in the Z direction with one of the intersections of the second grid portion 132 disposed therebetween.

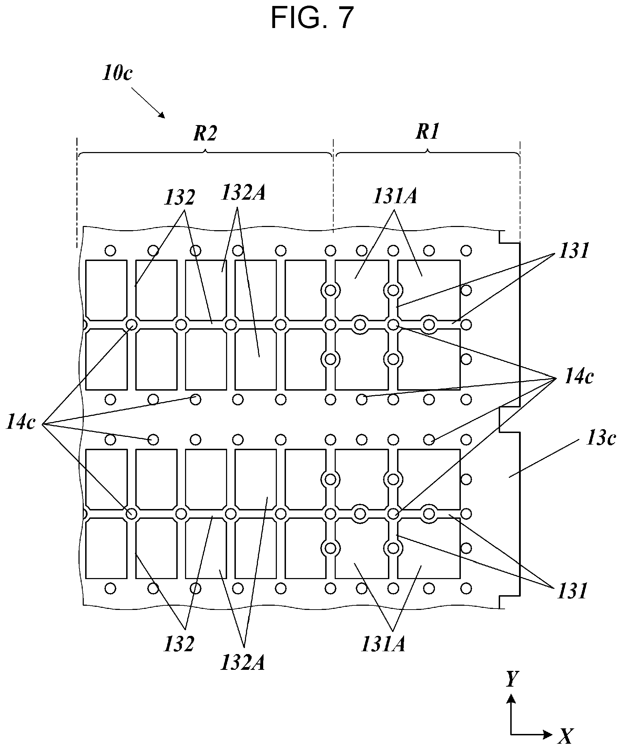

In FIG. 6, the through conductors 14c are arranged at equal intervals in the X direction in the first region R1 and the second region R2. However, the arrangement is not limited to this. As illustrated in FIG. 7, for example, the intervals between the through conductors 14c in the first region R1 may be less than the intervals between the through conductors 14c in the second region R2. In other words, the through conductors 14c may be arranged more densely in first region R1 than in the second region R2. As illustrated in FIG. 7, the through conductors 14c may be located at the intersections of the first grid portion 131.

As illustrated in FIG. 8, the fourth layer 10d includes a flat plate-shaped base 11d including a dielectric, a ground conductor 13d (second ground conductor), and through conductors 14d. The base 11d includes a first region R1 and a second region R2. The fourth layer 10d overlaps the third layer 10c such that the first region R1 of the base 11d and the first region R1 of the base 11c coincide in see-through plan view. The base 11d has a shape that is substantially the same as the shape of the base 11c in an area around the end thereof in the +X direction.

The ground conductor 13d is formed on an upper surface of the base 11d. The ground conductor 13d is located at a distance of less than λ/4 from the signal conductors 12 in the Z direction. The ground conductor 13d is further away from the first surface S1 than the ground conductor 13c of the third layer 10c. Therefore, the distance between the first surface S1 and the ground conductor 13d is greater than the distance between the first surface S1 and the ground conductor 13c.

The ground conductor 13d includes a plurality of third openings 133A in a mesh pattern in the first region R1. The shape and area of each of the third openings 133A are respectively the same as the shape and area of each of the first openings 131A of the third layer 10c. Accordingly, the third openings 133A have a rectangular shape with sides extending in the X direction and the Y direction, and the lengths of the third openings 133A in the X direction and the Y direction are λ/8 or more and λ/4 or less. Each of the third openings 133A overlaps one of the first openings 131A in plan view. The ground conductor 13d includes a third grid portion 133 including segments disposed between the third openings 133A that are adjacent to each other. The third grid portion 133 is a conductor including straight segments extending in the X direction and the Y direction. Each opening row composed of the third openings 133A arranged in one row in the X direction overlaps one of the signal conductors 12 in see-through plan view, as each opening row composed of the first openings 131A. The segments of the third grid portion 133 extending in the Y direction are orthogonal to the signal conductors 12 in see-through plan view. Thus, the ground conductor 13d includes the third grid portion 133 at a location (third location) overlapping the first region R1 and at least portions of the signal conductors 12 in see-through plan view.

For the purpose of impedance adjustment, the ground conductor 13d may include additional openings located to overlap the second openings 132A of the third layer 10c. The area of the third openings 133A may be less than the area of the first openings 131A within a range such that the lengths of the third openings 133A in the X direction and the Y direction are λ/8 or more and λ/4 or less.

An upper surface of the ground conductor 13d is connected to the through conductors 14c of the third layer 10c. Accordingly, the ground conductor 13d is electrically connected to the ground conductor 13c of the third layer 10c via the through conductors 14c and has the ground potential. The ground conductor 13d is also connected to the through conductors 14d extending through the base 11d in the Z direction.

As illustrated in FIG. 9, the fifth layer 10e includes a flat plate-shaped base 11e including a dielectric, a ground conductor 13e, and through conductors 14e. The base 11e includes a first region R1 and a second region R2. The fifth layer 10e overlaps the fourth layer 10d such that the first region R1 of the base 11e and the first region R1 of the base 11d coincide in see-through plan view. The base 11e has a shape that is substantially the same as the shape of the base 11d.

An upper surface of the ground conductor 13e is connected to the through conductors 14d of the fourth layer 10d. Accordingly, the ground conductor 13e is electrically connected to the ground conductor 13d of the fourth layer 10d via the through conductors 14d and has the ground potential. The ground conductor 13e is a solid conductor formed in a region including locations overlapping the third openings 133A of the fourth layer 10d in plan view. The ground conductor 13e extends over the mounting region r1 and a portion of the frame region r2.

The ground conductor 13e is also connected to the through conductors 14e extending through the base 11e in the Z direction. The through conductors 14e are connected to a ground conductor included in a sixth layer below the through conductors 14e. The ground conductor of the sixth layer may be connected to a ground conductor of a seventh layer below the sixth layer by through conductors extending through a base of the sixth layer. The ground potential can be stabilized by electrically connecting the ground conductors of multiple layers with the through conductors. The through conductors 14e may be omitted when the terminal member 10 include no layers below the sixth layer.

As described above, the base 11 of the terminal member 10 includes the bases 11a to 11e included in the first to fifth layers 10a to 10e, respectively. The ground conductor 13 of the terminal member 10 includes the ground conductors 13a to 13e included in the first to fifth layers 10a to 10e, respectively. The ground conductors 13b to 13e are located in the base 11. In the terminal member 10, the signal conductors 12 of the first layer 10a and the ground conductors 13b to 13e of the layers below the first layer 10a from a microstrip line.

The terminal member 10 may be formed by, for example, the following method.

The material of the bases 11a to 11e may be, for example, a ceramic sintered body, such as an aluminum-oxide-based sintered body, an aluminum-nitride-based sintered body, a silicon-carbide-based sintered body, a mullite-based sintered body, or a glass ceramic. When the material of the bases 11a to 11e is an aluminum-oxide-based sintered body, the base 11 of the terminal member 10 may be manufactured as follows. First, material powder is mixed with an organic solvent and a binder to form a slurry. The main components of the material powder are aluminum oxide powder and powder of silicon oxide or the like serving as a sintering aid component. Next, the slurry is formed into sheets by a forming method, such as the doctor blade method or the lip coater method. Thus, ceramic green sheets (hereinafter also referred to as green sheets) used to form the bases 11a to 11e are prepared. Next, the green sheets are stacked together to form a multilayer body. Then, the multilayer body is fired at a temperature of about 1300°C to about 1600°C to obtain the base 11.

The signal conductors 12 on the base 11a and the ground conductors 13a to 13e on the bases 11a to 11e, respectively, contain a metal material, such as tungsten, molybdenum, manganese, or copper, or an alloy of these metal materials as a conductor component. The signal conductors 12 and the ground conductors 13a to 13e composed of metallized layers of tungsten, for example, may be formed by mixing tungsten powder with an organic solvent and an organic binder to form a metal paste, printing the metal paste on the green sheets at predetermined positions by screen printing, and firing the metal paste. The through conductors 14a to 14e may be formed by forming through holes in the green sheets at predetermined positions prior to the printing of the metal paste, filling the through holes with a metal paste that is the same as or similar to the above-described metal paste, and firing the metal paste together with the green sheets. A nickel film with a thickness of about 1 to 10 µm and a gold film with a thickness of about 0.1 to 3 µm may be successively formed on surfaces of conductor layers, such as the signal conductors 12 and the ground conductors 13a, that are exposed to the outside to protect the surfaces and facilitate bonding with a brazing material, solder, or the like.

In the present embodiment, the wiring base 100 includes the terminal member 10 of the above-described structure. Therefore, the impedance of the terminal member 10 can be adjusted to an appropriate value. This will now be described.

In a general microstrip line, when a ground conductor below a signal conductor is a solid conductor layer, the resonant frequency shifts toward higher frequencies. As a result, the transmission characteristics for high-frequency signals are improved. On the other hand, as the distance between the signal conductor and the ground conductor decreases, the impedance decreases, and impedance matching becomes more difficult.

In contrast, in the present embodiment, the wiring base 100 is configured such that the ground conductor 13c below the signal conductors 12 includes the first openings 131A in a mesh pattern in the mounting region r1 (first region R1). Accordingly, the resonant frequency can be maintained, and reduction in the impedance can be reduced to enable adjustment of the impedance to a desired value. The above-described wiring base 100 has good transmission characteristics for high-frequency signals.

The second openings 132A in a mesh pattern are formed in a region further toward the cavity than the mounting region r1, that is, in the frame region r2 and in the cavity. Accordingly, the resonance frequency in a region around the mounting region r1 can be shifted toward higher frequencies. Therefore, the wiring base 100 of the above-described structure has good transmission characteristics for high-frequency signals. In addition, reduction in the impedance can be reduced.

In general, the resonant frequency of the microstrip line greatly depends on the cross-sectional shape of the wiring lines on a plane perpendicular to a signal transmission direction. Therefore, the resonant frequency is generally adjusted by adjusting the shapes of the signal conductors and the ground conductor in the mounting region r1. However, in practice, the electromagnetic field generated in the mounting region r1 also extends in a direction toward the cavity, and the shapes of the conductors extending in a direction parallel to the signal transmission direction, that is, the shapes of the conductors extending from the mounting region r1 and into the cavity, also affect the resonant frequency. Therefore, the wiring base 100, in which the ground conductor 13 includes the second openings 132A in a mesh pattern in a region further toward the cavity than the mounting region r1, has good transmission characteristics for high-frequency signals.

In addition to the third layer 10c including the first openings 131A, the fourth layer 10d also includes the third openings 133A in a mesh pattern in the mounting region r1. In other words, the openings in a mesh pattern are formed in two layers. Accordingly, reduction in the impedance can be further reduced. As described above, the signal conductors 12 include the signal terminals 12T in the mounting region r1. The signal terminals 12T has a line width (width in the Y direction in FIG. 3) with a lower limit determined by the design requirements for appropriate mounting of the external board 2. Therefore, the impedance may be reduced to a value below the desired value. In contrast, when two layers below the signal terminals 12T include openings in a mesh pattern, reduction in the impedance can be reduced to enable adjustment of the impedance to the desired value. Reduction in the impedance can also be reduced by setting the area of the first openings 131A to an area greater than the area of the second openings 132A.

The line width of each of the signal conductors 12 is not limited in a region further toward the cavity than the mounting region r1, for example, in the frame region r2. Therefore, reduction in the impedance can be reduced by reducing the width of each of the signal conductors 12. Accordingly, the area of the second openings 132A may be less than the area of the first openings 131A of the third layer 10c. The fourth layer 10d includes no openings in the second region R2 including the frame region r2. However, the fourth layer 10d is not limited to this, and may include openings in the second region R2 to enable further adjustment of the impedance.

When the lengths of the first openings 131A, the second openings 132A, and the third openings 133A in the X direction and the Y direction are λ/8 or more and λ/4 or less, electromagnetic waves generated by the transmission of a high-frequency signal are not easily transmitted. Accordingly, radiation of the electromagnetic waves to the outside can be reduced. When the lengths of the openings is λ/4 or less, a shift of the resonant frequency toward lower frequencies can be reduced. The wiring base 100 of the above-described structure has good transmission characteristics for high-frequency signals.

When the area of the first openings 131A is greater than the area of the second openings 132A, the impedance can be adjusted in consideration of the effective relative dielectric constant in regions in which the openings are formed. This will now be described.

The resonant frequency shifts toward higher frequencies as the size of the openings in a mesh pattern decreases. On the other hand, the impedance decreases as the size of the openings in a mesh pattern decreases. Therefore, the size of the openings is desirably increased while a high resonant frequency is maintained by setting the lengths of the openings to λ/4 or less. In the mounting region r1, which is in contact with air, the effective relative dielectric constant is lower than that in the frame region r2, which is in contact with the ceramic frame 22. Therefore, the wavelength λ of electromagnetic waves is longer in the mounting region r1 than in the frame region r2 when the frequency is constant. Accordingly, compared to the second grid portion 132 formed in the frame region r2, the first openings 131A formed in the mounting region r1 can be further increased in size while the condition that "the lengths of the openings are λ/4 or less" is satisfied. Thus, reduction in the impedance can be reduced without causing a shift of the resonant frequency toward lower frequencies. The wiring base 100 of the above-described structure has good transmission characteristics for high-frequency signals.

When the ground conductor 13c including the first openings 131A and the second openings 132A and the ground conductor 13d including the third openings 133A are located at distances of less than λ/4 from the signal conductors 12, the openings in a mesh pattern can be provided within an area in which the electromagnetic waves propagate. Accordingly, reduction in the impedance can be reduced. Therefore, the wiring base 100 of the above-described structure has good transmission characteristics for high-frequency signals.

The ground conductor 13e is disposed on the layer below the ground conductor 13d including the third openings 133A. The ground conductor 13e is a solid conductor formed over a region including locations overlapping the third openings 133A in plan view. Accordingly, radiation of the electromagnetic waves that pass through the first openings 131A and the third openings 133A to the outside of the electronic device 1 can be reduced.

Since the ground conductors 13c and 13d including the openings in a mesh pattern are electrically connected to each other via the through conductors 14c, the ground potential can be stabilized (enhanced). Accordingly, the transmission characteristics for high-frequency signals can be improved. The ground conductors 13c and 13d are also electrically connected to the ground conductors 13a, 13b, and 13e (and the ground conductors of the sixth and seventh layers that are further below) by other through conductors. Therefore, the ground potential can be further stabilized.

Since the distances between the through conductors 14c (and between the through conductors 14b connected thereto) are less than λ/4, leakage of electromagnetic waves generated by the transmission of a high-frequency signal in a direction toward the cavity can be reduced. In particular, leakage of the electromagnetic waves can be reduced by arranging the through conductors 14c more densely in the first region R1 (mounting region r1), in which the resonant frequency easily varies upon connection with the external board, than in the second region R2. When the through conductors 14c are located at the intersections of the first grid portion 131, and when the through conductors 14c are located at the intersections of the second grid portion 132, the through conductors 14c can be more densely arranged. To reduce leakage of the electromagnetic waves, the through conductors 14c are preferably arranged at a high density. When the distances between the through conductors are less than λ/4, the electrical connection between the ground conductors via the through conductors can be enhanced, and the ground potential can be stabilized accordingly.

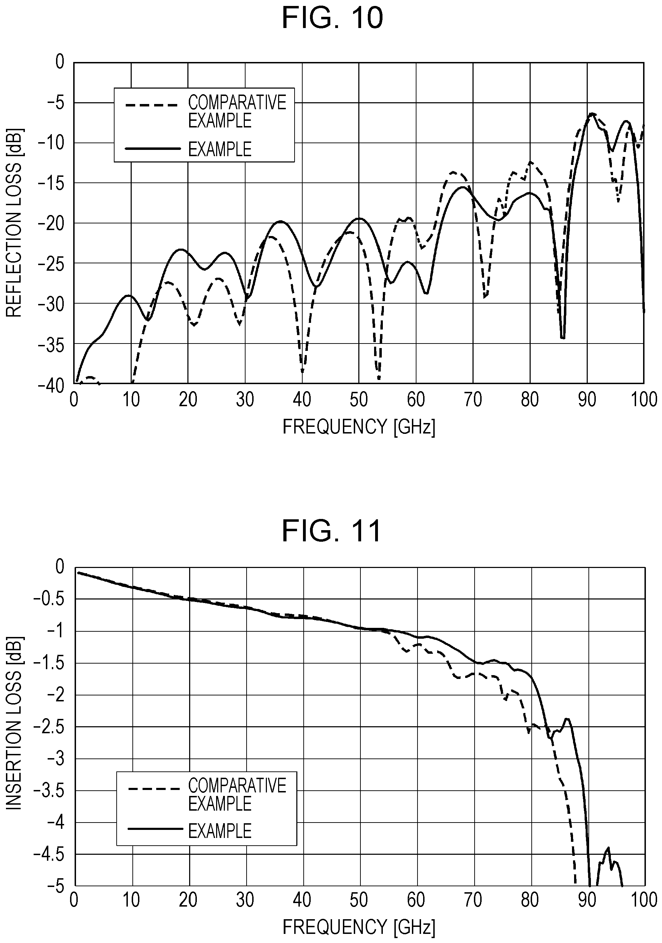

Results of simulations of reflection loss and insertion loss of the wiring base 100 according to the present embodiment will be described with reference to FIGs. 10 and 11.

In FIGs. 10 and 11, the solid lines indicate the simulation results of an example in which the first openings 131A, the second openings 132A, and the third openings 133A in a mesh pattern according to the present embodiment are provided. The dashed lines indicate the simulation results of a comparative example in which the ground conductor 13 of the terminal member 10 includes no openings in a mesh pattern.

As illustrated in FIG. 10, in a high-frequency band of 55 GHz to 85 GHz, the reflection loss (reflection of input increases as the reflection loss approaches 0) of the example is less than the reflection loss of the comparative example.

As illustrated in FIG. 11, in a high-frequency band of higher than or equal to 55 GHz, the insertion loss (loss increases as the absolute value of the insertion loss increases) of the example is less than the insertion loss of the comparative example.

As described above, in the present embodiment, the wiring base 100 includes the base 11, the signal conductors 12, and the ground conductor 13 including the ground conductor 13c as the first ground conductor. The base 11 includes the first surface S1, the first region R1, and the second region R2. The first region R1 is located near the outer side of the first surface S1. The external board 2 is mounted in the first region R1. The second region R2 is other than the first region R1. The signal conductors 12 extend along a region including the first region R1 of the first surface S1 in the X direction away from the outer side. The ground conductor 13c is located in the base 11 at a distance from the signal conductors 12 of less than 1/4 of the wavelength λ of the high-frequency signal in the direction perpendicular to the first surface S1, the high-frequency signal being transmitted through the signal conductors 12. The ground conductor 13c includes the first grid portion 131 at the first location overlapping the first region R1 and at least portions of the signal conductors 12 in see-through plan view viewed in a direction toward the first surface S1. The first grid portion 131 includes the segments disposed between the first openings 131A. The lengths of the first openings 131A in the X direction and the Y direction are λ/8 or more and λ/4 or less. The through conductors 14c are located on the first grid portion 131.

Since the ground conductor 13c includes the first openings 131A in a mesh pattern having the above-described size, the impedance can be adjusted to a desired value while the resonant frequency is maintained. When the through conductors 14c provide electrical connection between the ground conductor 13c and another ground conductor, the ground potential can be stabilized (enhanced). Thus, transmission characteristics for high-frequency signals can be improved.

When the first openings 131A have a rectangular shape with sides extending in the X direction and the Y direction, the first openings 131A having a desired area can be easily designed.

When the through conductors 14c are located at the intersections of the first grid portion 131, the through conductors 14c can be more densely arranged.

The ground conductor 13c includes the second grid portion 132 at the second location connected to the first grid portion 131 in the X direction and overlapping the second region R2 in see-through plan view. The second grid portion 132 includes the segments disposed between the second openings 132A. The lengths of the second openings 132A in the X direction and the Y direction are λ/8 or more and λ/4 or less. The area of the second openings 132A is less than the area of the first openings 131A. Accordingly, the frequency of the resonance that occurs around the mounting region r1 can be shifted toward higher frequencies to improve the transmission characteristics for high-frequency signals. In addition, reduction in the impedance can be further reduced. Since the area of the second openings 132A is less than the area of the first openings 131A, the impedance can be adjusted in consideration of the effective relative dielectric constant in regions in which the openings are formed.

When the second openings 132A have a rectangular shape with sides extending in the X direction and the Y direction, the second openings 132A having a desired area can be easily designed.

When the through conductors 14c are located at the intersections of the second grid portion 132, the through conductors 14c can be more densely arranged.

The ground conductor 13 is located in the base 11 at a distance of less than λ/4 from the signal conductors 12 in the direction perpendicular to the first surface S1. The ground conductor 13 includes the ground conductor 13d as the second ground conductor. The ground conductor 13d includes the third grid portion 133 at a third location overlapping the first region R1 and at least portions of the signal conductors 12 in see-through plan view. The third grid portion 133 includes segments disposed between the third openings 133A. The lengths of the third openings 133A in the X direction and the Y direction are λ/8 or more and λ/4 or less. The ground conductor 13d is further away from the first surface S1 than the ground conductor 13c in the direction perpendicular to the first surface S1, and is connected to the ground conductor 13c via the through conductors 14c. Thus, the openings in a mesh pattern are formed in two layers, and therefore reduction in the impedance can be further reduced. In addition, the electrical connection between the ground conductors can be enhanced, and the ground potential can be stabilized accordingly.

When the third openings 133A have a rectangular shape with sides extending in the X direction and the Y direction, the third openings 133A having a desired area can be easily designed.

The third openings 133A overlap the first openings 131A in see-through plan view. Thus, the openings in a mesh pattern are formed in two layers, and therefore reduction in the impedance can be reduced.

When the area of each of the third openings 133A is less than the area of each of the first openings 131A, the impedance can be adjusted within a desired range, and the design flexibility for the adjustment of the resonant frequency, for example, can be increased. Such an adjustment is enabled because the fourth layer 10d including the third openings 133A is further away from the signal conductors 12 than the third layer 10c including the first openings 131A.

The wiring base 100 includes the through conductors 14c, and the distance between adjacent ones of the through conductors 14c is less than λ/4. Accordingly, leakage of electromagnetic waves generated by the transmission of a high-frequency signal in a direction toward the cavity can be reduced. The electrical connection between the ground conductors via the through conductors can be enhanced, and accordingly the ground potential can be stabilized.

In the present embodiment, the electronic device 1 includes the above-described wiring base 100 and the electronic component 200 connected to the wiring base 100. Therefore, the electronic device 1 has good transmission characteristics for high-frequency signals.

### <Second Embodiment>

A second embodiment will now be described. In the second embodiment, the structure of the terminal member 10 differs from that in the first embodiment. The difference from the first embodiment will be described. In the second embodiment, the electronic device 1 and the wiring base 100 can be used for optical communication in a higher frequency band (for example, the modulation rate is about 128 Gbaud or less and the frequency band is about 95 GHz or less).

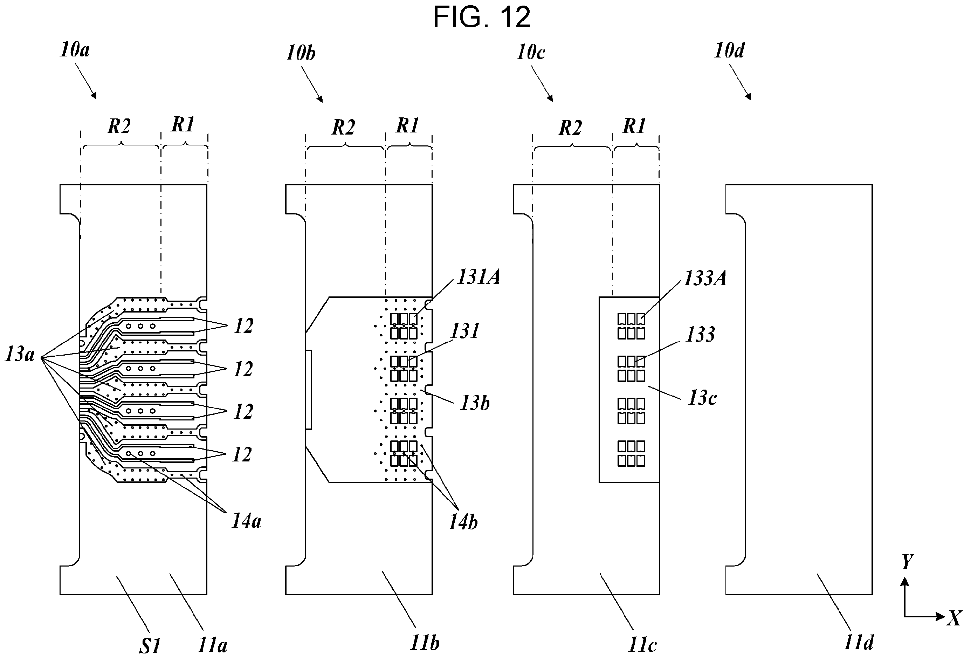

The structure of the terminal member 10 according to the second embodiment will be described with reference to FIG. 12.

In the second embodiment, the terminal member 10 includes a four-layer structure composed of a first layer 10a, a second layer 10b, a third layer 10c, and a fourth layer 10d.

The first layer 10a includes a base 11a, eight signal conductors 12, five ground conductors 13a, and through conductors 14a. Also in the second embodiment, the base 11a includes a first region R1 in which the external board 2 is mounted and a second region R2 including a frame region r2.

The second layer 10b includes a base 11b, a ground conductor 13b, and through conductors 14b. In the second embodiment, the ground conductor 13b corresponds to the "first ground conductor". The ground conductor 13b includes first openings 131A in the first region R1. In other words, the ground conductor 13b includes a first grid portion 131 including segments disposed between the first openings 131A. In the example illustrated in FIG. 12, the ground conductor 13b includes no second openings 132A. However, the second openings 132A may be formed when the second openings 132A are necessary for impedance adjustment.

The third layer 10c includes a base 11c and a ground conductor 13c. In the second embodiment, the ground conductor 13c corresponds to the "second ground conductor". The ground conductor 13c includes third openings 133A. The third openings 133A overlap the first openings 131A in see-through plan view. In other words, the ground conductor 13c includes a third grid portion 133 including segments disposed between the third openings 133A. The third layer 10c includes no through conductors.

The fourth layer 10d is composed of a dielectric base 11d, and include no conductors, such as a ground conductor and through conductors.

As described above, in the second embodiment, neither the first openings 131A nor the third openings 133A overlap the ground conductor 13 in see-through plan view. In other words, no solid conductor is located to overlap the first openings 131A or the third openings 133A in see-through plan view. Accordingly, reduction in the impedance can be further reduced. The resonant frequency can be further shifted toward higher frequencies to improve the transmission characteristics for high-frequency signals. Although an increase in the resonant frequency tends to cause a cavity resonance in which standing waves are generated in the cavity, the cavity resonance can be reduced because no solid conductor is provided (no shielding is provided) at the bottom layer. Accordingly, degradation of the transmission characteristics for high-frequency signals due to the influence of the cavity resonance can be reduced, and the resonant frequency can be further shifted toward higher frequencies.

### <Other Embodiments>

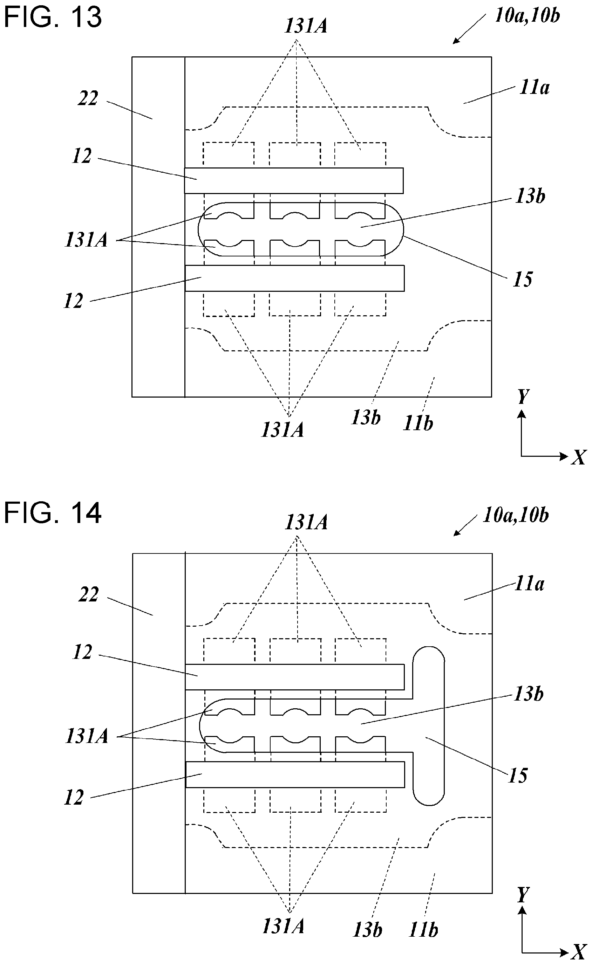

A terminal member 10 according to an embodiment other than the first and second embodiments will be described with reference to FIG. 13.

FIG. 13 is an enlarged partial view of the terminal member 10. FIG. 13 illustrates a first layer 10a and a second layer 10b of the terminal member 10. The second layer 10b is placed on a lower surface of the first layer 10a. A plurality of signal conductors 12 is formed on an upper surface of a base 11a of the first layer 10a. A ground conductor 13b is formed on an upper surface of a base 11b of the second layer 10b. The base 11a includes a groove 15 extending through the base 11a in the Z direction at a location between two adjacent ones of the signal conductors 12. In other words, the base 11 of the terminal member 10 includes the groove 15 extending from a first surface S1 to the layer including the ground conductor 13b serving as the first ground conductor. Although the groove 15 has an elongated circular shape extending in the direction in which the signal conductors 12 extend (X direction) in FIG. 13, the shape of the groove 15 is not limited to this, and may be, for example, a rectangular shape. The groove 15 may be a cut extending to an end of the base 11a. The ground conductor 13b partially overlaps the signal conductors 12 in see-through plan view. The ground conductor 13b includes a plurality of first openings 131A in a mesh pattern. The first openings 131A partially overlap the signal conductors 12 in see-through plan view. The first openings 131A also partially overlap the groove 15 in see-through plan view. In other words, the first openings 131A are partially exposed at the groove 15 when viewed in the Z direction (that is, in see-through plan view viewed in the direction toward the first surface S1). The ground conductor 13b of the second layer 10b is also partially exposed at the groove 15 when viewed in the Z direction.

Since the groove 15 is provided, the relative dielectric constant can be reduced in the region in which the groove 15 is formed. Therefore, reduction in the impedance of the signal conductors 12 can be reduced. Reduction in the impedance of the signal conductors 12 can also be reduced by forming the first openings 131A in a mesh pattern in the ground conductor 13b. Thus, according to the structure illustrated in FIG. 13, reduction in the impedance caused when the signal conductors 12 are brought closer to the ground conductor 13b to broaden the frequency band of the transmission line can be reduced, and the impedance can be adjusted to a desired value. Accordingly, the transmission characteristics for high-frequency signals can be improved, and the frequency band can be broadened.

As illustrated in FIG. 14, the groove 15 may be T-shaped. More specifically, the groove 15 is preferably shaped to include portions disposed on the extensions of the signal conductors 12 in the signal transmission direction. More specifically, the groove 15 preferably includes a portion extending in the X direction (signal transmission direction) at a location between the two adjacent signal conductors 12; a portion extending in the +Y direction from an end portion, in the +X direction, of the portion extending in the X direction; and a portion extending in the -Y direction from the end portion. The portion of the groove 15 extending in the +Y direction and the portion of the groove 15 extending in the -Y direction preferably extend to locations overlapping the extensions of the signal conductors 12 when the signal conductors 12 are extended in the +X direction. According to the above-described structure, when the signal conductors 12 are connected to an external board, such as an FPC, reduction in the impedance of the signal conductors 12 due to the connection to the external board can be reduced in regions around the connecting portions. Accordingly, high-frequency characteristics of the signal conductors 12, in particular, high-frequency characteristics in a common mode, can be improved.

The above-described embodiments are examples, and various changes are possible.

For example, although the first openings 131A, the second openings 132A, and the third openings 133A have a rectangular shape with sides extending in the X direction and the Y direction in the above-described embodiments, the shape is not limited to this.

For example, the first openings 131A, the second openings 132A, and the third openings 133A may have a shape with sides extending in a first direction and a second direction that are not orthogonal to each other, for example, the shape of a parallelogram or a rhomboid.

Alternatively, the first openings 131A, the second openings 132A, and the third openings 133A may have a polygonal shape other than a rectangular shape, a circular shape, or an elliptical shape.

Among the group of first openings 131A, the group of second openings 132A, and the group of third openings 133A, the openings of one or two groups may have a rectangular shape while the openings of the remaining group or groups have any of the above-described non-rectangular shapes.

Although the openings in a mesh pattern are formed in two layers in the above-described embodiments, the openings are not limited to this. The number of layers in which the openings in a mesh pattern are formed may be one or three or more.

The details of the configurations, structures, positional relationships, and shapes described above in the embodiments may be changed as appropriate without departing from the spirit of the present disclosure. The configurations, structures, positional relationships, and shapes described above in the embodiments may be combined as appropriate without departing from the spirit of the present disclosure.

### INDUSTRIAL APPLICABILITY

The present disclosure is applicable to wiring bases and electronic devices.

### REFERENCE SIGNS

1 electronic device
2 external board
10 terminal member
11, 11a to 11e base
12 signal conductor
12T signal terminal
13, 13a to 13e ground conductor
13T ground terminal
14a to 14e through conductor
15 groove
20 main body
21 bottom portion
22 frame
22a through hole
22b fitting portion
23 seal member
30 lid body
100 wiring base
200 electronic component
R1 first region
R2 second region
r1 mounting region
r2 frame region

## Claims

1. A wiring base comprising:
a base;
a signal conductor; and
a ground conductor comprising a first ground conductor,
wherein the base comprises:
a first surface;
a first region located near an outer side of the first surface, wherein an external board is mounted in the first region; and
a second region other than the first region,
wherein the signal conductor extends through a region comprising the first region of the first surface in a first direction away from the outer side;
wherein the first ground conductor is located in the base at a distance from the signal conductor of less than 1/4 of a wavelength of a high-frequency signal in a direction perpendicular to the first surface, the high-frequency signal being transmitted through the signal conductor, the first ground conductor comprising a first grid portion at a first location overlapping the first region and at least a portion of the signal conductor in a see-through plan view viewed in a direction toward the first surface, the first grid portion comprising a segment disposed between first openings,
wherein lengths of the first openings in the first direction and a second direction crossing the first direction are 1/8 or more and 1/4 or less of the wavelength of the high-frequency signal, and
wherein a through conductor is located on the first grid portion.

2. The wiring base according to claim 1, wherein the first openings have a rectangular shape with sides extending in the first direction and the second direction.

3. The wiring base according to claim 1 or 2, wherein the through conductor is located at an intersection of the first grid portion.

4. The wiring base according to any one of claims 1 to 3, wherein the first ground conductor comprises a second grid portion at a second location connected to the first grid portion in the first direction and overlapping the second region in the see-through plan view, the second grid portion comprising a segment disposed between second openings,
wherein lengths of the second openings in the first direction and the second direction are 1/8 or more and 1/4 or less of the wavelength of the high-frequency signal, and
wherein an area of the second openings is less than an area of the first openings.

5. The wiring base according to claim 4, wherein the second openings have a rectangular shape with sides extending in the first direction and the second direction.

6. The wiring base according to claim 4 or 5, wherein the through conductor is located at an intersection of the second grid portion.

7. The wiring base according to any one of claims 1 to 6, wherein the ground conductor comprises a second ground conductor located in the base at a distance from the signal conductor of less than 1/4 of the wavelength of the high-frequency signal in the direction perpendicular to the first surface, the second ground conductor comprising a third grid portion at a third location overlapping the first region and at least a portion of the signal conductor in the see-through plan view, the third grid portion comprising a segment disposed between third openings,
wherein lengths of the third openings in the first direction and the second direction are 1/8 or more and 1/4 or less of the wavelength of the high-frequency signal, and
wherein the second ground conductor is further away from the first surface than the first ground conductor in the direction perpendicular to the first surface, and is connected to the first ground conductor via the through conductor.

8. The wiring base according to claim 7, wherein the third openings have a rectangular shape with sides extending in the first direction and the second direction.

9. The wiring base according to claim 7 or 8, wherein the third openings overlap the first openings in the see-through plan view.

10. The wiring base according to any one of claims 7 to 9, wherein an area of each of the third openings is less than an area of each of the first openings.

11. The wiring base according to any one of claims 1 to 10, wherein the first openings do not overlap the ground conductor in the see-through plan view.

12. The wiring base according to any one of claims 7 to 10, wherein the third openings do not overlap the ground conductor in the see-through plan view.

13. The wiring base according to any one of claims 1 to 12, further comprising one or more through conductors,
wherein a distance between adjacent ones of the through conductors is less than 1/4 of the wavelength of the high-frequency signal.

14. The wiring base according to any one of claims 1 to 13, further comprising one or more signal conductors,
wherein the base comprises a groove at a location between adjacent ones of the signal conductors, the groove extending from the first surface to a layer comprising the first ground conductor, and
wherein the first openings are partially exposed at the groove in the see-through plan view viewed in the direction toward the first surface.

15. An electronic device comprising:
the wiring base according to any one of claims 1 to 14; and
an electronic component connected to the wiring base.
